(19) Europäisches Patentamt
European Patent Office
Office européen des brevets

(11) **EP 3 271 493 B1**

(12) **FASCICULE DE BREVET EUROPEEN**

(45) Date de publication et mention
de la délivrance du brevet:
**03.03.2021 Bulletin 2021/09**

(51) Int Cl.:
*C23C 14/06* *(2006.01)* *C23C 14/56* *(2006.01)*
*C23C 14/54* *(2006.01)* *C23C 14/02* *(2006.01)*
*C23C 14/04* *(2006.01)* *C23C 14/00* *(2006.01)*
*H01M 8/02* *(2016.01)* *H01M 8/0228* *(2016.01)*
*H01M 8/021* *(2016.01)* *H01M 8/1018* *(2016.01)*

(21) Numéro de dépôt: **15716141.5**

(22) Date de dépôt: **20.03.2015**

(86) Numéro de dépôt international:
**PCT/IB2015/052062**

(87) Numéro de publication internationale:
**WO 2016/151358 (29.09.2016 Gazette 2016/39)**

(54) **PROCÉDÉ DE FABRICATION D'UNE BANDE OU FEUILLE MÉTALLIQUE PRÉSENTANT UN REVÊTEMENT À BASE DE NITRURE DE CHROME.**

HERSTELLUNGSVERFAHREN FÜR METALLBAND ODER -BLECH MIT EINER CHROM-NITRIDBESCHICHTUNG.

MANUFACTURING METHOD OF A METAL STRIP OR SHEET HAVING A CHROMIUM-NITRIDE COATING.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**24.01.2018 Bulletin 2018/04**

(73) Titulaire: **Aperam**
**1882 Luxembourg (LU)**

(72) Inventeurs:
• **GIRARDON, Pauline**
**59120 Loos (FR)**
• **TAHON, Sébastien**
**62120 Wittes (FR)**
• **DAMASSE, Jean-Michel**
**59160 Lomme (FR)**
• **BERGER, Marie-Hélène**
**91170 Viry-Chatillon (FR)**
• **CORNIL, Hughes**
**4570 Marchin (BE)**
• **HENROTTE, Olivier**
**4590 Ouffet (BE)**
• **PIMARD, Alain**
**25150 Pont de Roide (FR)**

(74) Mandataire: **Lavoix**
**2, place d'Estienne d'Orves**
**75441 Paris Cedex 09 (FR)**

(56) Documents cités:
WO-A1-2013/124690 CN-A- 101 257 117
US-A1- 2005 238 873 US-A1- 2010 015 499
US-A1- 2012 118 724 US-A1- 2013 168 243

EP 3 271 493 B1

**Description**

La présente invention concerne un procédé de fabrication d'une bande ou feuille métallique comprenant un substrat constitué d'acier inoxydable revêtu d'au moins une couche de revêtement à base de nitrure de chrome.

Les piles à combustible de type PEMFC, c'est-à-dire à membrane d'échange de protons, comprennent des unités piles constituées chacune d'un assemblage anode/électrolyte/cathode, aussi appelé MEA (« membrane electrode assembly » en anglais), de couches de diffusion des gaz, aussi appelées GDL (« gaz diffusion layer » en anglais), s'étendant de part et d'autre de l'ensemble MEA, et de plaques bipolaires. Les plaques bipolaires assurent l'assemblage entre eux des éléments de l'unité pile. Elles délimitent en outre des canaux de circulation de fluides, assurent la distribution des gaz, du liquide de refroidissement et l'évacuation de l'eau générée dans la pile. Elles ont également pour fonction de collecter le courant généré aux électrodes.

Compte tenu du rôle essentiel joué par les plaques bipolaires au sein de la pile à combustible, ainsi que de l'importance croissante de telles piles dans de nombreux domaines, il est souhaitable de développer des plaques bipolaires compactes, peu coûteuses à fabriquer et présentant en outre une durée de vie importante en fonctionnement dans la pile à combustible.

US 2012/0118724, WO 2013/124690 et US 2005/0238873 décrivent des plaques bipolaires comprenant un substrat en acier inoxydable. et leur procédé de fabrication.

Un but de l'invention est donc de fournir des plaques bipolaires peu coûteuses à fabriquer et présentant en outre une durée de vie importante en fonctionnement dans la pile à combustible.

A cet effet, l'invention a pour objet le procédé selon la revendication 1.

L'invention sera mieux comprise à la lecture de la description qui va suivre, donnée uniquement à titre d'exemple, et faite en référence aux dessins annexés, sur lesquels :

- la figure 1 est une vue schématique d'une bande métallique fabriquée par le procédé de l'invention ;
- la figure 2 est une représentation schématique d'un procédé de fabrication de la bande de la figure 1 ;
- la figure 3 est une représentation schématique d'une installation de dépôt ;
- la figure 4 est une représentation schématique d'une plaque bipolaire fabriquée selon le procédé de l'invention ;
- la figure 5 est une image obtenue par traitement d'une image en microscopie électronique en transmission d'un flan issu de la bande de la figure 1 ;
- la figure 6 est une image analogue à celle de la figure 5 prise à titre de comparaison sur une bande qui n'est pas selon l'invention ;
- la figure 7 est une image au microscope électronique à balayage d'une plaque obtenue par emboutissage d'un flan issu de la bande de la figure 1 ;
- la figure 8 est une image analogue à celle de la figure 7 d'une plaque obtenue par emboutissage d'un flan issu d'une bande qui n'est pas selon l'invention ;
- la figure 9 est une image en microscopie électronique en transmission d'une plaque obtenue par emboutissage d'un flan issu de la bande de la figure 1 ; et
- la figure 10 est une image analogue à celle de la figure 9 obtenue à partir d'une plaque obtenue par emboutissage d'un flan issu d'une bande qui n'est pas selon l'invention ;
- la figure 11 est une vue schématique d'une bande métallique selon un autre mode de réalisation de l'invention ;
- la figure 12 est une représentation schématique d'une partie d'un procédé de fabrication de la bande de la figure 11 ;
- la figure 13 est une représentation schématique d'une installation de dépôt selon un premier mode de réalisation;
- la figure 14 est une représentation schématique d'une installation de dépôt qui n'est pas selon l'invention ;
- la figure 15 est une représentation schématique d'une installation de dépôt selon un deuxième mode de réalisation; et
- la figure 16 est une représentation schématique du montage de mesure de la résistance de contact.

Dans toute la description, l'expression « compris entre a et b » s'entend comme incluant les bornes a et b.

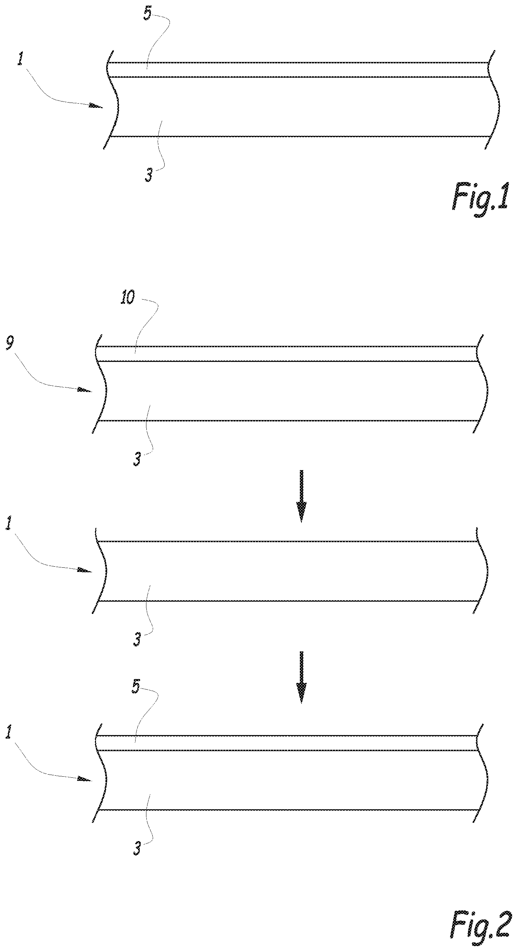

La bande métallique 1 illustrée sur la figure 1 comprend un substrat 3 en acier inoxydable et au moins une couche de revêtement 5.

Plus particulièrement, le substrat 3 est une bande réalisée en acier inoxydable, et notamment en acier inoxydable ferritique ou austénitique. A titre d'exemple, le substrat 3 est réalisé en inox 1.4404, 1.4306, 1.4510 ou 1.4509.

Le substrat 3 présente une épaisseur comprise entre 75 micromètres et 200 micromètres, et en particulier une épaisseur inférieure ou égale à 100 micromètres.

Le substrat 3 en forme de bande est obtenu par toute méthode conventionnelle adaptée, par exemple par laminage à chaud en une ou plusieurs passes, suivi d'un laminage à froid en une ou plusieurs passes, d'une brame réalisée dans l'alliage souhaité, la méthode pouvant comprendre un ou plusieurs traitement thermiques, notamment de recuit.

L'acier inoxydable du substrat 3 est polycristallin. Il est donc constitué d'une pluralité de grains. Les grains de l'acier formant le substrat 3 présentent une taille strictement inférieure à 50 micromètres, et en particulier comprise entre 10 micromètres et 30 micromètres.

La couche de revêtement 5 est une couche à base de nitrure de chrome de type CrN.

Comme on le verra par la suite, la couche à base de nitrure de chrome comprend éventuellement de l'oxygène dans des limites qui seront précisées plus loin.

A titre d'exemple, la couche de revêtement 5 à base de nitrure de chrome est constituée de $CrN_xO_y$, avec x compris entre 0,6 et 2 et y strictement inférieur à 1,4 et d'éventuelles impuretés, notamment d'impuretés résultant de la fabrication.

La somme de x et y est telle que la couche de revêtement 5 à base de nitrure de chrome présente la structure cristallographique cubique à faces centrées du $Cr_1N_1$. Cette structure cristallographique est connue de l'homme du métier.

La couche de revêtement 5 présente par exemple une épaisseur comprise entre 3 nm et 150 nm. Elle est plus particulièrement supérieure ou égale à 50 nm, et par exemple supérieure ou égale à 50 nm et inférieure ou égale à 100 nm.

La couche de revêtement 5 est obtenue par un procédé de dépôt physique en phase vapeur.

L'utilisation du procédé de dépôt physique en phase vapeur pour le dépôt de la couche de revêtement 5 à base de nitrure de chrome résulte en une microstructure distinctive de cette couche de revêtement. En particulier, la couche de revêtement 5 présente une structure colonnaire, avec des grains de taille sensiblement identique, voire comparable, à ceux de l'acier constituant le substrat 3.

La couche de revêtement 5 présente une direction de croissance normale au substrat 3.

L'utilisation du procédé de dépôt en phase vapeur résulte en une structure colonnaire de la couche de revêtement 5, constituée de colonnes de largeur comprise entre 10% et 20% de l'épaisseur de la couche de revêtement 5. A titre d'exemple, la largeur des colonnes est de l'ordre de 10 nanomètres.

Les colonnes de la couche de revêtement 5 croissent selon la direction de croissance de la couche de revêtement 5. Dans ce contexte, on entend par longueur de colonne, la dimension d'une colonne selon une direction normale au substrat 3 et par largeur la dimension d'une colonne dans un plan parallèle au plan moyen du substrat 3.

La couche de revêtement 5 de la bande métallique 1 est texturée d'un point de vue cristallographique. Cette texturation résulte de la mise en œuvre du procédé qui sera décrit par la suite.

Par "texturée" on entend que les directions cristallographiques de croissance des colonnes composant la couche de revêtement 5 ne sont pas aléatoires mais fortement orientées selon l'un des axes cristallographiques définissant la maille élémentaire du CrN. Dans ce cas, l'orientation relative des mailles élémentaires de la couche de revêtement 5 et du substrat 3 permet d'aligner les plans cristallographiques des deux phases présentant des distances inter-réticulaires voisines et d'assurer la continuité de ces plans cristallographiques perpendiculairement à l'interface entre le substrat 3 et la couche de revêtement 5.

De préférence, la couche de revêtement 5 présente une relation d'épitaxie avec le substrat 3. Par « épitaxie », on entend, de manière conventionnelle, que les trois axes cristallographiques des colonnes de la couche de revêtement 5 sont alignés avec ceux des grains du substrat 3 adjacents à ces colonnes.

Comme on le verra par la suite, une couche de revêtement 5 présentant une relation d'épitaxie avec le substrat 3 est particulièrement avantageuse.

La bande métallique 1 est avantageusement constituée du substrat 3 et d'une ou plusieurs couches de revêtement 5 à base de nitrure de chrome. En particulier, la couche de revêtement 5 à base de nitrure de chrome est formée directement sur l'acier inoxydable du substrat 3, sans interposition d'une couche intermédiaire, telle qu'une couche passive ou d'oxydation, résultant de l'oxydation naturelle de l'acier inoxydable constituant le substrat 3. Par oxydation naturelle, on entend l'oxydation à l'air, par exemple lors de l'utilisation ou du stockage du substrat 3 en acier inoxydable.

En outre, de préférence, la bande métallique 1 ne comprend pas de couches formées au-dessus de la couche de revêtement 5 la plus éloignée du substrat 3.

Un procédé d'obtention d'une bande métallique 1 selon l'invention sera maintenant expliqué en référence à la figure 2.

Dans une première étape, on fournit une bande métallique 9 comprenant un substrat 3 réalisé en acier inoxydable recouvert, à sa surface, d'une couche passive 10 à base d'oxyde de chrome formée par oxydation naturelle de l'acier inoxydable constituant le substrat 3. Une telle couche passive d'oxyde de chrome se forme à la surface de l'acier inoxydable dès que celui-ci entre en contact avec l'air. Elle est à la base du caractère inoxydable de l'acier inoxydable. La couche passive 10 peut classiquement comprendre, outre l'oxyde de chrome, et de façon minoritaire, des oxydes d'autres éléments chimiques présents dans l'acier formant le substrat 3.

Dans une deuxième étape, on décape entièrement la couche passive 10 dans certaines zones au moins de la bande métallique 9 de sorte que, dans ces zones, il ne subsiste aucun reste de couche passive 10.

De préférence, au cours de la deuxième étape, la couche passive 10 est décapée sur toute la surface du substrat 3 destiné à être revêtu de la couche de revêtement 5.

Le décapage est réalisé par un procédé de décapage physique. De préférence, le décapage est un décapage ionique, réalisé par bombardement de la bande métallique initiale par un gaz neutre. Le gaz neutre utilisé est par exemple de l'argon. En variante, il peut s'agir de tout autre gaz neutre adapté.

Un tel procédé de décapage ionique est connu en tant que tel et ne sera pas décrit plus en détail par la suite.

A l'issue de ce décapage, on obtient le substrat 3 présentant les atomes métalliques de l'acier inoxydable à sa surface dans les zones dans lesquelles le décapage a été réalisé.

Au cours d'une troisième étape, on dépose par dépôt physique en phase vapeur (aussi appelé « PVD » ou « physical vapor deposition » en anglais) au moyen d'une installation de dépôt physique en phase vapeur 14, du nitrure de chrome sur le substrat 3 dans les zones dans lesquelles la couche passive 10 a été décapée.

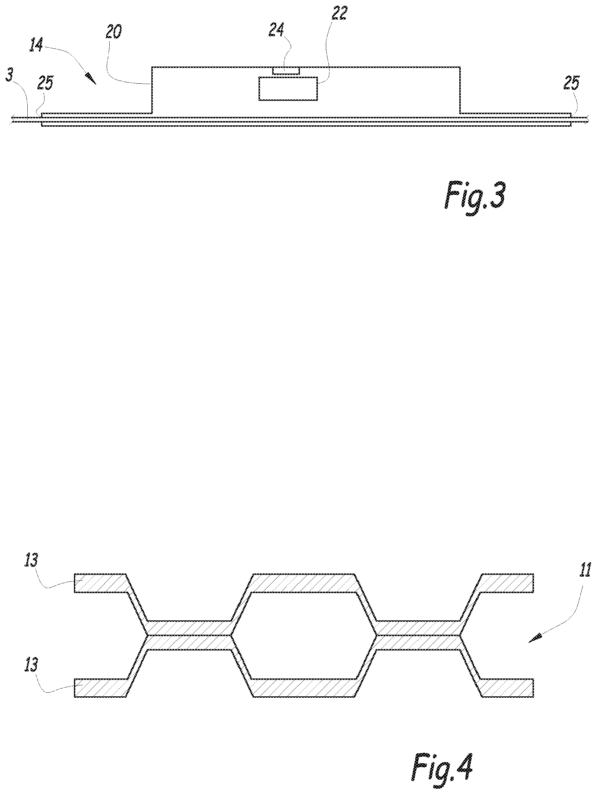

De manière conventionnelle, l'installation de dépôt physique en phase vapeur 14, représentée sur la figure 3, comprend une enceinte de dépôt 20, propre à être mise sous vide et une cible 22. La cible 22 est constituée de chrome.

Le substrat 3 défile à travers l'enceinte 20 selon une direction de défilement, appelée direction longitudinale dans la suite. Dans toute la description, les termes amont et aval sont utilisés en référence au défilement du substrat 3 à travers l'enceinte 20.

L'enceinte 20 comprend, à chacune de ses extrémités longitudinales, une ouverture de passage 25 du substrat 3. Les ouvertures 25 sont avantageusement étanchéifiées.

Dans l'exemple représenté, l'enceinte 20 comprend une source de gaz inerte 24. Ce gaz inerte est par exemple de l'argon.

Le procédé PVD utilisé est avantageusement un procédé de pulvérisation cathodique. Dans ce cas, la cible 22 est dite « cible de pulvérisation cathodique ». L'enceinte 20 comprend des moyens d'application d'une différence de potentiel entre la cible 22 et le substrat 3, de telle sorte que la cible 22 forme la cathode de l'installation de dépôt 14 et le substrat 3 forme l'anode de l'installation de dépôt 14.

Le dépôt de la couche de revêtement 5 sur le substrat 3 est réalisé par bombardement de la cible 22 au moyen du gaz inerte provenant de la source de gaz inerte 24 dans une atmosphère comprenant également de l'azote.

Plus précisément, et comme illustré sur la figure 3, au cours de l'étape de dépôt, le substrat 3 en forme de bande défile à travers l'enceinte 20.

Une différence de potentiel adaptée est appliquée entre la cible 22 et le substrat 3.

Le gaz inerte projeté, sous forme de plasma, sur la cible 22, extrait des atomes de chrome de celle-ci, lesquels se condensent ensuite sur le substrat 3 de sorte à former la couche de revêtement 5 à base de nitrure de chrome, le chrome se combinant à l'azote présent dans l'enceinte 20.

Le dépôt est réalisé sur un substrat 3 à température ambiante, par exemple de l'ordre de 20°C.

Au cours de cette étape de dépôt, le débit d'azote injecté dans l'enceinte 20 est ajusté afin d'obtenir la stœchiométrie souhaitée de l'azote dans la couche de revêtement 5 à base de nitrure de chrome. La constance de la stœchiométrie de dépôt est assurée par l'analyse du spectre de la lumière émise par le plasma lors du dépôt du revêtement par PVD. En effet, l'analyse de ce spectre permet de déduire les concentrations relatives de chrome et d'azote présentes dans le plasma.

Les débits précis d'azote à utiliser en fonction de la stœchiométrie varient en fonction de l'installation de dépôt PVD utilisée. Cependant, l'homme du métier est capable, au moyen de ses connaissances générales et au travers d'un nombre limité d'essais de calibration reliant le spectre de lumière émis par le plasma et des mesures de stœchiométrie des couches de revêtement obtenues pour différents débits d'azote, de déterminer le débit d'azote à employer, pour une installation donnée, en fonction de la stœchiométrie souhaitée dans la couche de revêtement 5.

On forme ainsi la couche de revêtement 5 à base de nitrure de chrome directement sur le substrat 3 en acier inoxydable, sans interposition d'une couche passive. La couche de revêtement 5 obtenue à l'issue de cette étape est texturée. Plus particulièrement, elle présente une relation d'épitaxie avec le substrat 3.

A l'issue de la troisième étape, on obtient ainsi la bande métallique 1.

Une plaque bipolaire 11 est représentée sur la figure 4.

Telle que représentée sur la figure 4, la plaque bipolaire 11 comprend deux plaques 13 solidarisées entre elles, notamment par soudage. Plus particulièrement, les plaques 13 délimitent, après leur solidarisation, des canaux de distribution et d'évacuation de fluides.

Chaque plaque 13 est obtenue à partir d'une bande métallique 1. Plus particulièrement, elle est obtenue par déformation, en particulier à froid, d'un flan découpé à partir de la bande métallique 1.

Chaque plaque 13 comprend ainsi un substrat 3 en acier inoxydable, revêtu d'au moins une couche de revêtement 5 à base de nitrure de chrome, tel que décrit précédemment en relation avec la bande métallique 1.

La forme finale des plaques 13 est avantageusement obtenue par emboutissage à froid d'un flan découpé à partir de la bande métallique 1.

L'invention concerne également un procédé de fabrication d'une plaque bipolaire 11 à partir d'une bande métallique 1 comprenant :

- la fourniture d'une plaque 13 comprenant un substrat 3 en acier inoxydable, revêtu d'au moins une couche de revêtement 5 à base de nitrure de chrome, tel que décrit précédemment ; et

- la solidarisation de cette plaque 13 à une autre plaque, et avantageusement à une autre plaque 13 analogue, de manière à former la plaque bipolaire 11.

L'étape de fourniture de la plaque 13 comprend :

- le découpage de la bande métallique 1 pour former au moins un flan ; et
- la déformation de ce flan, notamment par emboutissage, pour former une plaque 13.

Comme expliqué précédemment, la déformation est avantageusement une déformation à froid, et notamment un emboutissage à froid.

La solidarisation entre elles des deux plaques pour former la plaque bipolaire 11 est réalisée par toute méthode adaptée, et en particulier par soudage.

Les inventeurs de la présente invention ont réalisé les expériences suivantes.

Ils ont mis en œuvre, sur une bande métallique 9 telle que décrite précédemment, le procédé de fabrication d'une bande métallique 1 tel que représenté sur la figure 1, et ont ainsi obtenu une bande métallique 1.

Ils ont ensuite découpé des flans à partir de cette bande métallique 1. Ils ont imagé ces flans par microscopie électronique en transmission (ou MET) et analysé les images ainsi obtenues par des techniques connues d'analyse d'image pour vérifier s'il existait une relation d'épitaxie entre le substrat 3 et la couche de revêtement 5.

Plus particulièrement, ils ont calculé les transformées de Fourier des images obtenues par MET, les transformées de Fourier permettant d'explorer les distributions fréquentielles des images obtenues par MET. Sur les images transformées de Fourier, ils ont sélectionné les fréquences correspondant aux plans cristallographiques du substrat 3 et de la couche de revêtement 5 pour lesquelles on observe une orientation voisine dans l'espace des fréquences. Ils ont ensuite obtenu les images finales par transformée de Fourier inverse filtrées à partir des fréquences sélectionnées.

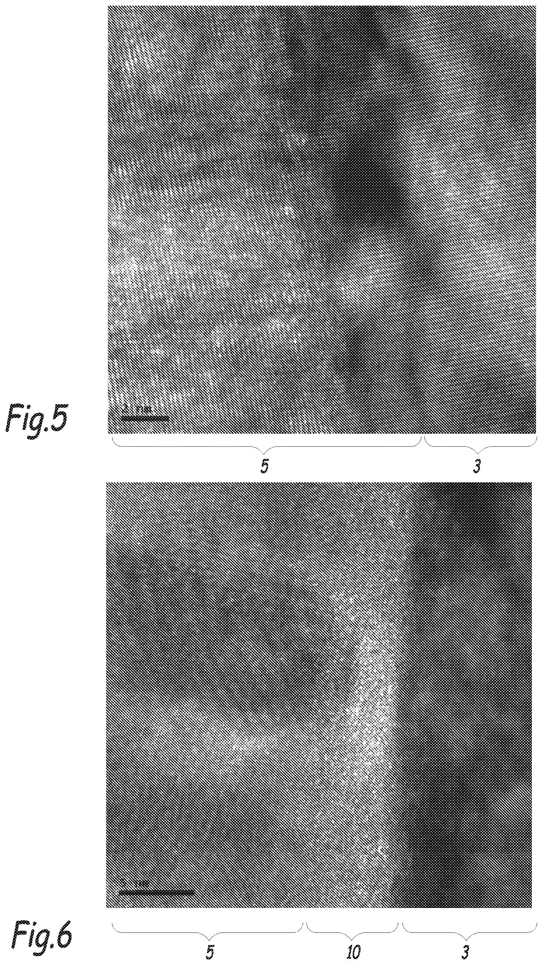

Un exemple d'image obtenue après analyse est représenté sur la figure 5. Dans cette figure, les traits diagonaux représentent les plans atomiques. La continuité de ces traits au passage de l'interface entre le substrat 3 et la couche de revêtement 5 montre que la couche de revêtement 5 présente une relation d'épitaxie avec le substrat 3.

Les inventeurs ont réalisé de telles analyses pour des bandes métalliques 1 obtenues avec différents débits d'azote lors de l'étape de dépôt de la couche de revêtement 5. Ils ont observé que la relation d'épitaxie entre le substrat 3 et la couche de revêtement 5 existe quel que soit le débit d'azote utilisé.

A titre de comparaison, les inventeurs ont réalisé des expériences avec des bandes métalliques obtenues par un procédé différant du procédé selon l'invention uniquement par le fait qu'au cours de la deuxième étape, la couche passive 10 n'a pas été entièrement décapée dans les zones du substrat 3 revêtues avec la couche de revêtement 5. Ainsi, cette couche passive 10 subsiste dans des zones revêtues ensuite avec la couche de revêtement 5 à base de nitrure de chrome, et est interposée entre la couche de revêtement 5 et le substrat 3.

La figure 6 illustre un exemple d'image obtenue après analyse d'une image MET d'une telle bande, qui n'est pas selon l'invention, selon la méthode d'analyse expliquée ci-dessus. Dans ce cas, on constate qu'il n'y a pas de continuité des plans atomiques à l'interface entre le substrat 3 et la couche de revêtement 5. Sur cette image, la zone blanche entre le substrat 3 et la couche de revêtement 5 correspond à la couche passive 10.

Ainsi, les inventeurs ont observé que la relation d'épitaxie entre la couche de revêtement 5 et le substrat 3 n'est pas obtenue lorsque la couche passive 10 n'a pas été décapée, ou n'a pas été entièrement décapée avant revêtement dans les zones du substrat 3 destinées à être recouvertes de la couche de revêtement 5.

Les inventeurs ont ensuite déformé par emboutissage des flans obtenus par découpage d'une bande métallique 1 selon l'invention pour obtenir des plaques 13.

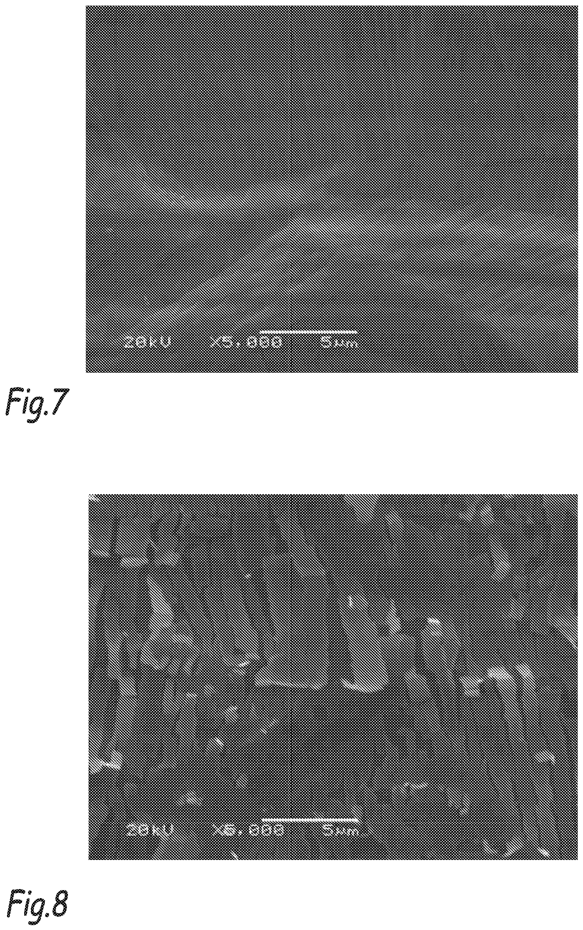

La figure 7 est une image au microscope électronique à balayage d'une plaque 13 ainsi obtenue. Sur cette image, on n'observe aucun décollement entre la couche de revêtement 5 et le substrat 3 résultant de l'emboutissage. Ainsi, la couche de revêtement 5 présente une adhérence satisfaisante sur le substrat 3. Or, une bonne adhérence de la couche de revêtement 5 est particulièrement avantageuse lors de l'utilisation de la bande 1 dans une plaque bipolaire. En effet, elle permet d'assurer à la plaque bipolaire de bonnes propriétés électriques, en particulier une bonne conductivité électrique, et évite un empoisonnement de l'électrolyte.

La figure 8 est une image au microscope électronique à balayage d'une plaque obtenue par emboutissage de flans obtenus par découpage de la bande qui n'est pas selon l'invention décrite ci-dessus. Sur cette image, on observe un décollement de la couche de revêtement 5. Ainsi, l'adhérence de la couche de revêtement 5 est, dans ce cas, insuffisante pour résister à la déformation par emboutissage du flan.

On notera que, dans le cadre de l'invention, la déformation par emboutissage du flan obtenu à partir de cette bande métallique 1 pour former une plaque 13 peut résulter en une plaque 13 présentant une couche de revêtement 5 non continue.

En effet, du fait des propriétés mécaniques différentes du substrat 3 et de la couche de revêtement 5, l'emboutissage résulte en un allongement relatif bien supérieur du substrat 3 par rapport à la couche de revêtement 5. Du fait de la bonne adhérence entre le substrat 3 et la couche de revêtement 5 selon l'invention, cet allongement différentiel résulte en la formation de microfissures 26 dans la couche de revêtement 5 de la plaque 13, et donc en la formation d'une couche de revêtement discontinue sur la plaque 13. Ces microfissures 26 se forment en particulier entre deux colonnes adjacentes de la couche de revêtement 5. La couche passive se reforme naturellement dans ces microfissures 26 par oxydation naturelle de l'acier inoxydable du substrat 3, qui affleure dans ces zones.

Les inventeurs ont observé que, même en présence de microfissures 26, il ne se produit aucune perte de revêtement lors de l'emboutissage de flans obtenus à partir de bandes 1 obtenues selon l'invention.

Par ailleurs, grâce à la bonne adhérence entre la couche de revêtement 5 et le substrat 3, la couche de revêtement 5 ne se décolle pas du substrat 3 lors de l'emboutissage et on observe, dans la plaque 13, une très bonne adhérence entre la couche de revêtement 5 discontinue et le substrat 3.

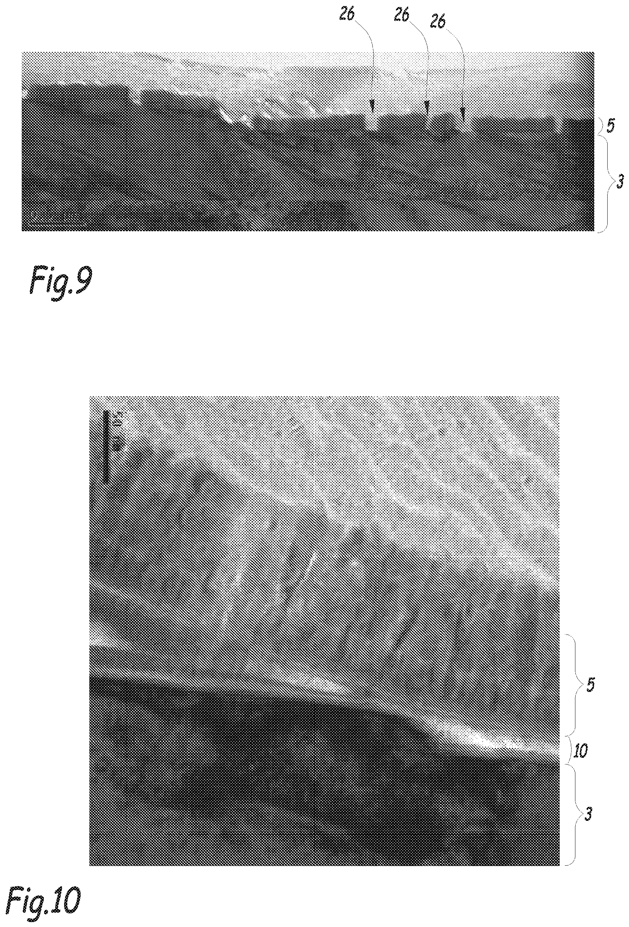

La figure 9, qui est une image en microscopie électronique en transmission d'une plaque 13 selon l'invention, illustre ces observations.

Les inventeurs ont mesuré la conductivité électrique d'une telle couche discontinue et ont constaté que les performances électriques restaient satisfaisantes, malgré la présence des microfissures 26. La couche passive qui se reforme après emboutissage entre les colonnes adjacentes de la couche de revêtement 5 ne nuit pas à la conductivité électrique et protège l'acier inoxydable du substrat 3 dans les zones où il affleure.

La figure 10 est une image en microscopie électronique en transmission d'une plaque obtenue par emboutissage à partir de la bande qui n'est pas selon l'invention décrite précédemment. Dans ce cas, on observe que la couche de revêtement 5 s'est décollée du substrat 3 et a glissé d'une pièce en réponse à l'allongement du substrat 3 sous l'effet de l'emboutissage. Dans la plaque ainsi obtenue, la couche de revêtement 5 n'adhère donc plus au substrat 3. Or, on cherche à éviter un tel décollement, qui nuit à la conductivité électrique de la plaque bipolaire et risque de conduire à un empoisonnement de l'électrolyte de la pile à combustible.

La bande métallique 1 est particulièrement adaptée pour la fabrication de plaques bipolaires présentant une durée de vie importante pour des coûts de fabrication réduits.

En effet, l'acier inoxydable est un matériau peu coûteux et qui présente en outre des propriétés très avantageuses pour son utilisation en tant que plaque bipolaire. En particulier, il présente d'excellentes propriétés mécaniques. Il est en outre emboutissable, soudable, imperméable aux gaz, et présente une forte conductivité électrique dans son épaisseur, ainsi qu'une bonne conductivité thermique.

Cependant, lorsqu'un substrat nu en acier inoxydable est utilisé dans des plaques bipolaires de piles à combustible, ces plaques bipolaires présentent des propriétés électriques insuffisantes. La couche de revêtement texturée à base de nitrure de chrome selon l'invention confrère de bonnes propriétés de conduction électrique à la plaque bipolaire, résultant notamment de l'excellente adhésion de la couche de revêtement au substrat 3.

Selon une variante, la description concerne une feuille métallique ou flan obtenu par découpe de la bande métallique 1.

La feuille métallique obtenue par le procédé de l'invention pourrait également être obtenue par un procédé analogue à celui décrit précédemment pour l'obtention de la bande 1, mais en partant d'une feuille métallique au cours de la première étape du procédé, plutôt que d'une bande.

Une telle feuille présente des propriétés identiques à celles de la bande 1.

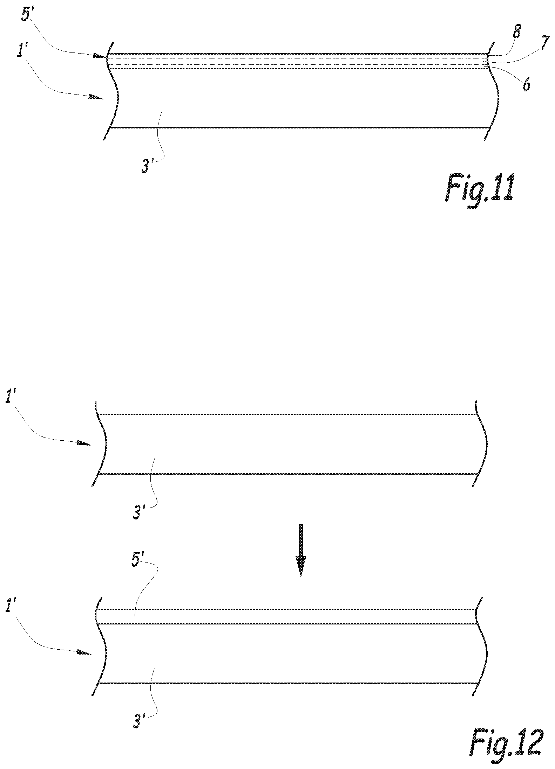

Une bande métallique 1' selon un autre mode de réalisation sera maintenant décrite en regard de la figure 11. Cette bande 1' présente toutes les caractéristiques de la bande 1, et en particulier ses propriétés de texturation, mais présente en outre les caractéristiques spécifiques décrites ci-après.

Comme cela est illustré sur la figure 11, la couche de revêtement 5' de la bande 1' est constituée de trois zones superposées selon la direction de croissance de la couche de revêtement 5', c'est-à-dire selon la direction normale au plan moyen du substrat 3'. Chaque zone s'étend sur toute la surface de la couche de revêtement 5', prise parallèlement au plan moyen du substrat 3'. De préférence, chaque zone présente une épaisseur sensiblement constante.

Plus particulièrement, la couche de revêtement 5' est constituée, en partant du substrat 3' et en se dirigeant vers la surface de la couche de revêtement 5', selon la direction normale au plan moyen du substrat 3', d'une zone d'interface 6, d'une zone de cœur 7 et d'une zone de surface 8.

La zone de surface 8 de la couche de revêtement 5' est localisée à la surface de la couche de revêtement 5'.

La zone de surface 8 présente une teneur atomique en oxygène strictement inférieure à sa teneur atomique en azote. On considère que l'écart entre le rapport de la teneur atomique en oxygène sur la teneur atomique en chrome et le rapport de la teneur atomique en azote sur la teneur atomique en chrome dans la zone de surface 8 est de préférence supérieur ou égal à 0,1.

La zone de surface 8 présente une composition du type : $CrN_{x1}O_{y1}$, avec y1 strictement inférieur à x1, le reste étant constitué d'éventuelles impuretés, notamment d'impuretés résultant de la fabrication. Ces impuretés n'incluent pas d'oxygène. L'écart entre x1 et y1 est de préférence au moins égal à 0,1.

Le coefficient x1 correspond au rapport de la teneur atomique en azote sur la teneur atomique en chrome dans la zone de surface 8. Le coefficient y1 correspond au rapport de la teneur atomique en oxygène sur la teneur atomique en chrome dans la zone de surface 8.

La somme des coefficients x1 et y1 est telle que la zone de surface 8 présente la structure cristallographique cubique à faces centrées du $Cr_1N_1$.

x1 est avantageusement compris entre 0,6 et 2.

Indépendamment de la valeur de x1, y1 est avantageusement inférieur ou égal à 1,4, tout en étant strictement inférieur à x1, et en étant tel que la zone de surface 8 conserve la structure cristallographique du $Cr_1N_1$.

En particulier, la zone de surface 8 s'étend sur au moins 5% de l'épaisseur de la couche de revêtement 5'. Elle s'étend au plus sur environ 15% de l'épaisseur de la couche de revêtement 5'.

Aucune couche d'oxydation, qui résulterait de l'oxydation de la couche de revêtement 5', n'est formée sur la zone de surface 8.

La zone d'interface 6 de la couche de revêtement 5' est localisée à l'interface avec le substrat 3'. Elle est en contact direct avec l'acier constituant le substrat 3'. Elle forme la partie de la couche de revêtement 5' la plus proche du substrat 3'.

Avantageusement, la zone d'interface 6 présente une teneur atomique en oxygène strictement inférieure à sa teneur atomique en azote. L'écart entre le rapport de la teneur atomique en oxygène sur la teneur atomique en chrome et le rapport de la teneur atomique en azote sur la teneur atomique en chrome dans la zone d'interface 6 est de préférence supérieur ou égal à 0,1.

La zone d'interface 6 présente une composition du type : $CrN_{x2}O_{y2}$, avec y2 strictement inférieur à x2, le reste étant constitué d'éventuelles impuretés, notamment d'impuretés résultant de la fabrication. Ces impuretés n'incluent pas d'oxygène. L'écart entre x2 et y2 est de préférence au moins égal à 0,1.

Le coefficient x2 correspond au rapport de la teneur atomique en azote sur la teneur atomique en chrome dans la zone d'interface 6. Le coefficient y2 correspond au rapport de la teneur atomique en oxygène sur la teneur atomique en chrome dans la zone d'interface 6.

La somme des coefficients x2 et y2 est telle que la zone de d'interface 6 présente la structure cristallographique cubique à faces centrées du $Cr_1N_1$.

x2 est avantageusement compris entre 0,6 et 2.

Indépendamment de la valeur de x2, y2 est avantageusement inférieur ou égal à 1,4, tout en étant strictement inférieur à x1, et en étant tel que la zone d'interface 6 conserve la structure cristallographique du $Cr_1N_1$.

En particulier, la zone d'interface 6 s'étend sur au moins 1% de l'épaisseur de la couche de revêtement 5'. Elle s'étend au plus sur environ 15% de l'épaisseur de la couche de revêtement 5'. Plus particulièrement, elle s'étend sur au plus 10% de l'épaisseur de la couche de revêtement 5'.

La zone de cœur 7 de la couche de revêtement 5' forme le cœur de la couche de revêtement 5'. Elle s'étend, selon la direction normale au plan moyen du substrat 3', entre la zone d'interface 6 et la zone de surface 8. Elle constitue la majeure partie de l'épaisseur de la couche de revêtement 5'. Avantageusement, elle s'étend sur au moins 70% de l'épaisseur de la couche de revêtement 5'.

En particulier, la zone de cœur 7 présente une teneur atomique en oxygène strictement inférieure au tiers de sa teneur atomique en azote. En d'autres termes, elle présente une composition du type : $CrN_{x3}O_{y3}$, avec y3 strictement inférieur à $\dfrac{x3}{3}$, le reste étant constitué d'éventuelles impuretés, notamment d'impuretés résultant de la fabrication. Ces impuretés n'incluent pas d'oxygène.

Le coefficient x3 correspond au rapport de la teneur atomique en azote sur la teneur atomique en chrome dans la zone de cœur 7. Le coefficient y3 correspond au rapport de la teneur atomique en oxygène sur la teneur atomique en chrome dans la zone de cœur 7.

La somme des coefficients x3 et y3 est telle que la zone de cœur 7 présente la structure cristallographique cubique à faces centrées du $Cr_1N_1$.

x3 est avantageusement compris entre 0,6 et 2.

Indépendamment de la valeur de x3, y3 est avantageusement inférieur ou égal à 1,4, tout en étant strictement inférieur à $\dfrac{x3}{3}$, et en étant tel que la zone de cœur 7 conserve la structure cristallographique du $Cr_1N_1$.

Une couche de revêtement 5' présentant une zone de surface 8 telle que définie ci-dessus, dans laquelle la teneur atomique en oxygène est strictement inférieure à la teneur atomique en azote, est particulièrement avantageuse pour l'utilisation en tant que plaque bipolaire dans des piles à combustible. En effet, les inventeurs ont constaté que, lorsque la teneur atomique en oxygène dans la zone de surface 8 est strictement inférieure à la teneur atomique en azote, la résistance de contact (« Interfacial Contact Résistance » ou ICR en anglais) mesurée entre une feuille découpée à partir d'une telle bande et une couche de diffusion des gaz de référence SGL Group 34BC, est inférieure à 10 m$\Omega$.cm$^2$

à 100 N.cm$^{-2}$.

Au contraire, les inventeurs ont constaté que lorsque la teneur atomique en oxygène de la zone de surface 8 est supérieure ou égale à sa teneur atomique en azote, on mesure des résistances de contact très supérieures, au moins égales à 100 mΩ.cm$^2$ à 100 N.cm$^{-2}$, ce qui n'est pas entièrement satisfaisant pour son utilisation en tant que plaque bipolaire dans une pile à combustible.

De plus, les inventeurs ont constaté que lorsque la couche de revêtement 5' comprend, dans sa zone d'interface 6, une teneur atomique en oxygène strictement inférieure à sa teneur atomique en azote, la couche de revêtement 5' présente une meilleure adhérence au substrat 3' qu'une couche de revêtement dans laquelle cette condition n'est pas respectée. Cette propriété est particulièrement avantageuse lorsque la bande 1 est utilisée pour fabriquer des plaques bipolaires de piles à combustible. En effet, une adhérence insuffisante de la couche de revêtement 5' sur le substrat 3' augmente les risques de son décollement lors de la mise en forme, notamment par emboutissage, un tel décollement risquant de détériorer les propriétés de conduction électrique de la plaque bipolaire.

Une partie d'un procédé de fabrication d'une bande métallique 1' comprenant une couche de revêtement 5' est illustré schématiquement sur la figure 12.

Les deux premières étapes du procédé (fourniture de la bande métallique comprenant le substrat 3' et une couche passive et décapage de la couche passive) sont identiques à celles décrites précédemment en référence à la bande métallique 1. Sur la figure 12, ces étapes n'ont pas été représentées, seule la troisième étape étant illustrée.

La troisième étape ne diffère de la troisième étape du procédé décrit précédemment que par les caractéristiques mentionnées ci-après.

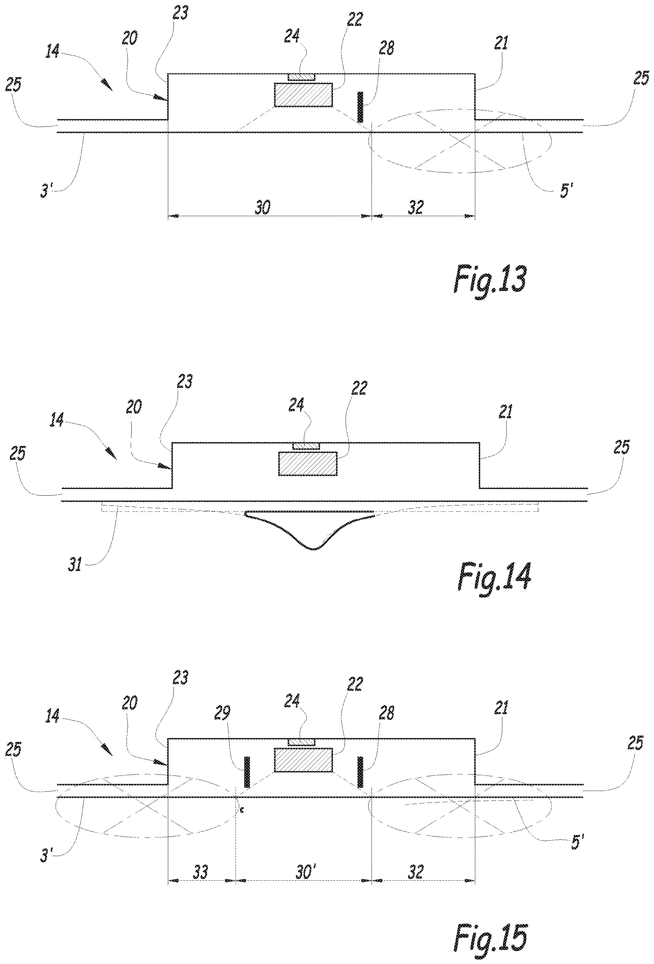

Selon ce mode de réalisation, et comme illustré sur la figure 13, l'enceinte de dépôt 20 comprend une zone de dépôt 30 et une première zone dite « interdite » 32, adjacente à la zone de dépôt 30 selon la direction longitudinale. Une zone interdite est définie comme une zone de l'enceinte 20 située sur le parcours du substrat 3' dans laquelle on ne souhaite pas qu'il se produise de revêtement à base de chrome.

La longueur de la zone de dépôt 30 est strictement inférieure à la longueur de l'enceinte de dépôt 20. Plus particulièrement, la zone de dépôt 30 présente une longueur strictement inférieure à la longueur de la zone de l'enceinte 20 dans laquelle du chrome se déposerait sur le substrat 3' en l'absence de zone interdite 32.

La zone de dépôt 30 et la première zone interdite 32 sont donc délimitées de telle sorte que, lors du dépôt, le nitrure de chrome est déposé sur le substrat 3' uniquement dans la zone de dépôt 30 et on empêche le dépôt de nitrure de chrome sur le substrat 3' dans la première zone interdite 32.

La première zone interdite 32 est située en aval de la cible 22 sur le parcours du substrat 3'.

La zone de dépôt 30 et la première zone interdite 32 sont configurées de telle sorte que, dans toute la partie de la zone de dépôt 30 localisée en aval de la cible 22 sur le parcours du substrat 3', la vitesse de dépôt des atomes de chrome sur le substrat 3' est supérieure ou égale à une vitesse seuil prédéterminée. La première zone interdite 32 correspond à une zone dans laquelle les atomes de chrome issus de la cible 22 seraient déposés sur le substrat 3' à une vitesse strictement inférieure à la vitesse seuil s'ils étaient libres de se déposer selon leur trajectoire naturelle.

En effet, les inventeurs ont constaté que la teneur en oxygène du revêtement est localement strictement supérieure à la teneur souhaitée définie précédemment dans les zones du revêtement formées par le dépôt d'atomes de chrome à une vitesse strictement inférieure à la vitesse seuil prédéterminée.

La vitesse seuil prédéterminée est égale à un pourcentage de la vitesse maximale de dépôt des atomes de chrome sur le substrat 3'. La vitesse de dépôt est maximale en en regard de la cible 22. Elle diminue en s'écartant de la cible 22, selon la direction longitudinale, sur le parcours du substrat 3'.

La valeur de la vitesse seuil prédéterminée est obtenue expérimentalement par l'homme du métier, pour une installation de dépôt donnée, par un nombre limité d'expériences. Elle correspond à la vitesse minimale de dépôt des atomes de chrome sur le substrat 3' en aval de la cible 22 pour laquelle on mesure une résistance de contact de la couche de revêtement obtenue inférieure à 10 mΩ.cm$^2$ à 100 N.cm$^{-2}$.

A titre d'exemple, dans le cas de l'appareil utilisé par les inventeurs de la présente invention, cette vitesse seuil est égale à environ 10% de la vitesse maximale de dépôt.

Afin de déposer le nitrure de chrome sur le substrat 3' uniquement dans la zone de dépôt 30, la deuxième étape comprend la mise en place d'au moins un cache aval 28 dans l'enceinte de dépôt 20, ledit cache aval 28 étant destiné à empêcher la projection d'atomes de chrome sur le substrat 3' à partir de la cible 22 en dehors de la zone de dépôt 30.

Le cache 28 empêche la projection d'atomes de chrome sur le substrat 3' dans la première zone interdite 32, dans laquelle la vitesse de dépôt des atomes de chrome sur le substrat 3' serait strictement inférieure au seuil donné. Le cache aval 28 est disposé sur la trajectoire des atomes de chrome qui, en l'absence du cache aval 28, seraient déposés sur le substrat 3', en aval de la cible 22 selon le parcours du substrat 3', avec une vitesse de dépôt strictement inférieure à la vitesse seuil prédéterminée, et empêche ainsi le dépôt de ces atomes de chrome sur le substrat 3'.

Le cache 28 est disposé entre la cible 22 et le substrat 3'. Le cache 28 est disposé à distance de la paroi aval 21 de l'enceinte 20. La première zone interdite 32 s'étend en aval du cache 28.

A titre d'exemple, le cache 28 est formé par une plaque imperméable aux atomes de chrome provenant de la cible 22. Il est disposé sensiblement normalement au substrat 3' défilant à travers l'enceinte 20.

Les inventeurs ont découvert que la délimitation dans l'enceinte de dépôt 20 d'une telle zone de dépôt 30, associée à une première zone interdite 32, permet de former sur le substrat 3' une couche de revêtement 5' comprenant une zone de surface 8 telle que définie précédemment, présentant une teneur atomique en oxygène strictement inférieure à sa teneur atomique en azote.

On notera que l'oxygène éventuellement présent dans la couche de revêtement 5' résulte des inévitables imperfections d'étanchéité de l'enceinte 20 et de la désorption à partir des parois de l'enceinte 20 ou même du substrat 3'.

Selon un mode de réalisation alternatif, la limite aval de la zone de dépôt 30 est déterminée en mesurant le profil de teneur atomique en oxygène dans une couche de revêtement à base de nitrure de chrome formée dans l'enceinte de dépôt en l'absence de délimitation de zone interdite, et en en déduisant la zone de l'enceinte 20, dans laquelle la zone de surface de la couche de revêtement présente une teneur atomique en oxygène strictement inférieure à sa teneur atomique en azote.

On obtient ainsi une couche de revêtement 5' comprenant une zone de surface 8 telle que définie précédemment, dans laquelle la teneur atomique en oxygène est strictement inférieure à la teneur atomique en azote.

La localisation de la zone de dépôt obtenue selon cette variante est sensiblement identique à la localisation déterminée au moyen des vitesses de dépôt.

La figure 14 illustre une enceinte qui ne relève pas de l'invention, du fait de l'absence de zone interdite, mais qui illustre la nécessité de prévoir de telles zones. Sur cette figure, on a représenté une courbe 31, obtenue par les inventeurs, montrant l'évolution de la teneur atomique en oxygène dans la couche de revêtement à base de nitrure de chrome obtenue dans une telle enceinte. Sur cette courbe, on observe que la teneur atomique en oxygène dans cette couche de revêtement, déposée dans des conditions identiques aux conditions selon l'invention, mais en l'absence de zones interdites, est minimale dans les parties de la couche de revêtement 5' déposées en regard de la cible 22. Cette teneur atomique en oxygène augmente dans les parties de la couche de revêtement 5' déposées en direction des extrémités amont et aval de l'enceinte 20 selon la direction de défilement du substrat 3', en étant maximale au voisinage de ces extrémités.

En option, la deuxième étape du procédé comprend en outre, préalablement au dépôt de la couche de revêtement 5', la minimisation du taux de dégazage de l'enceinte 20 afin de minimiser la quantité de gaz résiduels dans l'enceinte 20 autant que possible. Cette minimisation est notamment réalisée par pompage des gaz résiduels de l'enceinte 20.

La détermination de la présence minimale et maximale d'oxygène dans l'atmosphère de l'enceinte 20 pourra être effectuée par l'expérience en fonction des conditions locales de mise en œuvre de l'invention.

Par « taux de dégazage », on entend les débits de tous les gaz qui se désorbent de toutes les surfaces de l'enceinte 20 et qui s'ajoutent au débit contrôlé d'azote. Ce dégazage agit comme une perturbation ou une pollution chimique vis-à-vis du dépôt par PVD réalisé dans l'enceinte de dépôt 20.

La couche de revêtement 5' est avantageusement réalisée en une seule passe de revêtement, c'est-à-dire par un seul passage dans l'enceinte de dépôt 20.

A l'issue de l'étape de dépôt, on obtient une bande métallique 1' comprenant une couche de revêtement 5' présentant une zone de surface 8 telle que définie précédemment.

Le procédé de fabrication selon un deuxième mode de réalisation ne diffère du procédé qui vient d'être décrit qu'en ce que, comme cela est représenté sur la figure 15, la zone de dépôt 30' est limitée, non seulement en aval de la cible 22 comme décrit ci-avant, mais également en amont de la cible 22 sur le parcours du substrat 3'. Dans ce mode de réalisation, la zone de dépôt 30' est délimitée de telle sorte que la vitesse de dépôt des atomes de chrome sur le substrat 3' soit supérieure ou égale à la vitesse seuil décrite précédemment dans toute la zone de dépôt 30'.

Dans ce mode de réalisation, l'enceinte 20 comprend alors une deuxième zone interdite 33, adjacente à la zone de dépôt 30' en amont de la cible 22 sur le parcours du substrat 3. La première zone interdite 32 et la deuxième zone interdite 33 encadrent la zone de dépôt 30' selon la direction longitudinale. La première zone interdite 32 et la deuxième zone interdite 33 sont des zones dans lesquelles les atomes de chrome se déposeraient sur le substrat 3' à une vitesse strictement inférieure à la vitesse seuil prédéterminée s'ils étaient libres de se déposer selon leur trajectoire naturelle.

Afin de déposer le nitrure de chrome sur le substrat 3' uniquement dans la zone de dépôt 30', la deuxième étape comprend la mise en place, dans l'enceinte de dépôt 20, d'un cache 28 aval tel que défini précédemment, et d'un cache amont 29.

Le cache aval 28 et le cache amont 29 sont configurés pour empêcher la projection d'atomes de chrome sur le substrat 3' à partir de la cible 22 en dehors de la zone de dépôt 30', c'est-à-dire dans les zones de l'enceinte 20 dans lesquelles la vitesse de dépôt des atomes de chrome sur le substrat 3' est strictement inférieure au seuil donné. Ils sont disposés sur la trajectoire des atomes de chromes qui seraient, en l'absence de caches 28, 29, déposés sur le substrat 3' respectivement dans la première zone interdite 32 ou dans la deuxième zone interdite 33, et empêchent le dépôt d'atomes de chrome dans ces zones 32, 33.

Le cache aval 28 et le cache amont 29 sont disposés de part et d'autre de la cible 22, selon la direction de défilement du substrat 3'.

Dans l'exemple représenté, les caches 28, 29 sont équidistants de la cible 22, et la zone de dépôt 30' est centrée sur la cible 22. Dans cet exemple, la zone de dépôt 30' s'étend en regard de la cible 22, dans une région centrale de l'enceinte 20.

A titre d'exemple, le cache amont 29 est formé par une plaque imperméable aux atomes de chrome provenant de la cible 22. Il est disposé sensiblement normalement au substrat 3' défilant à travers l'enceinte 20.

Le cache amont 29 est disposé à distance de la paroi amont 23 de l'enceinte 20.

A titre d'exemple, dans l'installation utilisée par les inventeurs, les caches 28, 29 étaient espacés entre eux de 90 cm.

Les inventeurs de la présente invention ont constaté que la délimitation de la zone de dépôt 30' en amont de la cible 22, notamment au moyen du cache amont 29, permet d'obtenir une couche de revêtement 5' comprenant, dans sa zone d'interface 6, une teneur atomique en oxygène strictement inférieure à sa teneur atomique en azote. Comme cela a été expliqué précédemment, une telle couche de revêtement 5' présente une meilleure adhérence au substrat 3' qu'une couche dans laquelle cette condition n'est pas respectée.

Ainsi, lorsque la zone de dépôt 30' est délimitée en amont et en aval de la cible 22 de la manière précisée ci-dessus, on obtient, à l'issue de l'étape de dépôt, une couche de revêtement 5' comprenant, à sa surface, la zone de surface 8 telle que définie précédemment et, à l'interface entre le substrat 3' et la couche de revêtement 5', la zone d'interface 6 telle que définie précédemment.

Par ailleurs, cette couche de revêtement 5' comprend, entre la zone d'interface 6 et la zone de surface 8, une zone de cœur 7 telle que définie précédemment.

Selon une variante du deuxième mode de réalisation, les limites amont et aval de la zone de dépôt 30' sont déterminées en mesurant le profil de teneur atomique en oxygène dans une couche de revêtement à base de nitrure de chrome formée sur un substrat dans des conditions identiques aux conditions selon l'invention, mais en l'absence de délimitation de zones interdites dans l'enceinte, et en en déduisant la zone de l'enceinte 20 dans laquelle la zone de surface et la zone d'interface d'une telle couche de revêtement présentent une teneur atomique en oxygène strictement inférieure à sa teneur atomique en azote.

La localisation de la zone de dépôt 30' obtenue selon cette variante est sensiblement identique à la localisation déterminée au moyen des vitesses de dépôt.

A l'issue de l'étape de dépôt, on obtient une bande métallique 1' selon l'invention.

Des plaques 13, ainsi qu'une plaque bipolaire 11 présentant le revêtement 5' peuvent être obtenues par un procédé identique au procédé décrit précédemment pour la bande métallique 1, mais appliqué à la bande métallique 1'.

Comme cela a été expliqué précédemment, la bande métallique 1' selon l'invention est particulièrement adaptée pour la réalisation de telles plaques bipolaires 11.

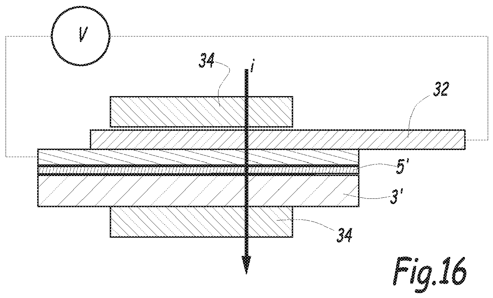

Les inventeurs ont notamment mesuré, pour trois échantillons de bande métallique différents portant une couche de revêtement à base de nitrure de chrome, la résistance de contact (ICR) entre l'échantillon et une couche de diffusion des gaz d'une pile à combustible au moyen du montage représenté sur la figure 16.

Les échantillons 1 et 2 sont des échantillons de bandes 1', obtenus selon le deuxième mode de réalisation du procédé décrit ci-dessus par pulvérisation cathodique dans une enceinte de dépôt 20 comprenant un cache amont 29 et un cache aval 28. L'échantillon 3 est issu d'une bande qui n'est pas selon l'invention.

Comme illustré sur la figure 16, la résistance de contact est mesurée en enserrant un ensemble formé par une couche de diffusion des gaz 32 de référence et une feuille obtenue par découpage à partir de la bande à tester entre deux plaques de cuivre 34, puis en appliquant un courant d'intensité connue I à cet ensemble. La couche de diffusion des gaz 32 utilisée par les inventeurs est une couche de référence 34BC commercialisée par SGL Group.

On mesure alors la différence de potentiel entre la couche de diffusion 32 et la surface de la feuille, et on en déduit la résistance de contact entre la feuille et la couche de diffusion 32.

Cette méthode de mesure de la résistance de contact d'une plaque bipolaire de pile à combustible est classique et bien connue de l'homme du métier.

Les inventeurs ont également déterminé expérimentalement la composition de la zone de surface 8 de la couche de revêtement.

Le tableau 1 ci-dessous reproduit les résultats de ces expériences.

Tableau 1 : Résistances de contact mesurées pour les échantillons testés

| Echantillon | x1 | y1 | Résistance de contact (ICR) mesurée (m$\Omega$.cm$^2$) |
|---|---|---|---|
| 1 | 1,0 | 0,8 | 4,8 |

(suite)

| Echantillon | x1 | y1 | Résistance de contact (ICR) mesurée (m$\Omega$.cm$^2$) |
|---|---|---|---|
| 2 | 0,9 | 0,8 | 5,7 |
| 3 | 0,8 | 1,4 | 105 |

Dans ce tableau, on constate que l'on obtient des valeurs de résistance de contact inférieures à 10 m$\Omega$.cm$^2$ à 100 N.cm$^{-2}$ pour des revêtements présentant des zones de surface dans lesquelles la teneur atomique en oxygène est, selon l'invention, strictement inférieure à la teneur atomique en azote dans la zone de surface (échantillons 1 et 2). Au contraire, dans le cas de l'échantillon 3, où la teneur atomique en oxygène est supérieure ou égale à la teneur atomique en azote dans la zone de surface du revêtement, et qui n'est donc pas un échantillon selon l'invention, la résistance de contact est supérieure à 100 m$\Omega$.cm$^2$ à 100 N.cm$^{-2}$. Elle est donc très supérieure à 10 m$\Omega$.cm$^2$ à 100 N.cm$^{-2}$.

Les inventeurs ont également mesuré, pour les échantillons 1 à 3, la composition de la zone d'interface 6 et de la zone de cœur 7. Les résultats de ces mesures sont reproduits dans le tableau 2 ci-dessous.

Tableau 2 : Compositions mesurées des zones de cœur et des zones d'interface des couches de revêtement

| Echantillon | x2 | y2 | x3 | y3 |
|---|---|---|---|---|
| 1 | 0,9 | 0,4 | 1,3 | 0,4 |
| 2 | 1,1 | 0,3 | 1,0 | 0,3 |
| 3 | 0,8 | 0,8 | 0,77 | 0,44 |

Comme cela a été expliqué précédemment, les inventeurs de la présente invention ont également découvert que la composition particulière de la zone d'interface 6 de la couche de revêtement 5' selon l'invention est avantageuse. En effet, les inventeurs ont observé que l'adhérence de la couche de revêtement 5' est particulièrement bonne lorsque la teneur atomique en oxygène de la zone d'interface 6 est strictement inférieure à sa teneur atomique en azote. Ainsi, le risque de décollement de la couche de revêtement 5' du substrat 3' lors de la déformation du flan obtenu à partir de la bande 1' pour former les plaques 13, par exemple par emboutissage, est minimisé. On cherche à éviter un tel décollement, car il risque de compromettre l'intégrité de la plaque bipolaire 11 ou denuire à sa conductivité électrique et peut résulter en un empoisonnement de l'électrolyte.

L'obtention de la teneur atomique en oxygène avantageuse de la zone de surface 8 résulte de la présence de la première zone interdite 22, c'est-à-dire de la limitation du dépôt de nitrure de chrome en aval de la cible 22 dans le procédé de fabrication de la bande métallique 1' selon les premier et deuxième modes de réalisation.

L'obtention de la teneur atomique en oxygène avantageuse de la zone d'interface 6 résulte de la présence de la deuxième zone interdite 23, c'est-à-dire de la limitation du dépôt de nitrure de chrome en amont de la cible 22 dans le procédé de fabrication de la bande métallique 1' selon le deuxième mode de réalisation.

En particulier, des mesures ont montré qu'un dépôt de nitrure de chrome réalisé sur le substrat en acier inoxydable dans une enceinte de dépôt 20 placée sous vide et dont on a minimisé, avant dépôt, le taux de dégazage, mais en permettant au nitrure de chrome de se déposer selon sa trajectoire naturelle, sans limitation de la zone de dépôt par exemple par des caches, résulte en une couche de revêtement présentant des teneurs atomiques en oxygène très en-dehors des plages décrites ci-avant, en particulier dans la zone d'interface et dans la zone de surface de la couche de revêtement. Dans ce cas, les inventeurs ont obtenu une couche de revêtement présentant une résistance de contact (ICR) supérieure à 100 m$\Omega$.cm$^2$ à 100 N.cm$^{-2}$ et présentant, en outre une adhérence moins bonne que lorsque la zone de dépôt est limitée en amont de la cathode de dépôt.

Ainsi, une simple minimisation de la présence d'oxygène dans l'enceinte de dépôt 20 par des techniques conventionnelles ne permet pas d'obtenir la couche de revêtement 5' telle que décrite précédemment.

Selon une variante, cette description concerne une feuille métallique ou flan obtenu par découpe de la bande métallique 1'.

La feuille métallique pourrait également être obtenue par un procédé analogue à celui décrit précédemment pour l'obtention de la bande 1', mais en partant d'un substrat 3' en forme de feuille, plutôt que d'un substrat 3' en forme de bande. Une telle feuille présente des propriétés identiques à celles de la bande 1'.

L'invention a été décrite pour une couche de revêtement 5, 5' formée sur une face du substrat 3, 3'. En variante, la bande métallique 1, 1', ainsi que les plaques 13 et les plaques bipolaires 11 fabriquées à partir de cette bande 1, 1' peuvent comprendre une couche de revêtement 5, 5' du type défini précédemment sur chacune de leurs faces.

Une telle couche de revêtement sur les deux faces du substrat 3 ; 3' peut être obtenue en un seul passage ou en plusieurs passages, par exemple deux passages, dans l'enceinte de dépôt 20.

Comme cela a été expliqué précédemment, les inventeurs de la présente invention ont également découvert que la composition particulière de la zone d'interface 6 de la couche de revêtement 5' selon l'invention est avantageuse. En effet, les inventeurs ont observé que l'adhérence de la couche de revêtement 5' est particulièrement bonne lorsque la teneur atomique en oxygène de la zone d'interface 6 est strictement inférieure à sa teneur atomique en azote. Ainsi, le risque de décollement de la couche de revêtement 5' du substrat 3' lors de la déformation du flan obtenu à partir de la bande 1' pour former les plaques 13, par exemple par emboutissage, est minimisé. On cherche à éviter un tel décollement, car il risque de compromettre l'intégrité de la plaque bipolaire 11 ou denuire à sa conductivité électrique et peut résulter en un empoisonnement de l'électrolyte.

L'obtention de la teneur atomique en oxygène avantageuse de la zone de surface 8 résulte de la présence de la première zone interdite 22, c'est-à-dire de la limitation du dépôt de nitrure de chrome en aval de la cible 22 dans le procédé de fabrication de la bande métallique 1' selon les premier et deuxième modes de réalisation.

L'obtention de la teneur atomique en oxygène avantageuse de la zone d'interface 6 résulte de la présence de la deuxième zone interdite 23, c'est-à-dire de la limitation du dépôt de nitrure de chrome en amont de la cible 22 dans le procédé de fabrication de la bande métallique 1' selon le deuxième mode de réalisation.

En particulier, des mesures ont montré qu'un dépôt de nitrure de chrome réalisé sur le substrat en acier inoxydable dans une enceinte de dépôt 20 placée sous vide et dont on a minimisé, avant dépôt, le taux de dégazage, mais en permettant au nitrure de chrome de se déposer selon sa trajectoire naturelle, sans limitation de la zone de dépôt par exemple par des caches, résulte en une couche de revêtement présentant des teneurs atomiques en oxygène très en-dehors des plages décrites ci-avant, en particulier dans la zone d'interface et dans la zone de surface de la couche de revêtement. Dans ce cas, les inventeurs ont obtenu une couche de revêtement présentant une résistance de contact (ICR) supérieure à 100 m$\Omega$.cm$^2$ à 100 N.cm$^{-2}$ et présentant, en outre une adhérence moins bonne que lorsque la zone de dépôt est limitée en amont de la cathode de dépôt.

Ainsi, une simple minimisation de la présence d'oxygène dans l'enceinte de dépôt 20 par des techniques conventionnelles ne permet pas d'obtenir la couche de revêtement 5' telle que décrite précédemment.

Selon une variante, l'invention concerne une feuille métallique ou flan obtenu par découpe de la bande métallique 1'.

La feuille métallique obtenue pourrait également être obtenue par un procédé analogue à celui décrit précédemment pour l'obtention de la bande 1', mais en partant d'un substrat 3' en forme de feuille, plutôt que d'un substrat 3' en forme de bande. Une telle feuille présente des propriétés identiques à celles de la bande 1'.

L'invention a été décrite pour une couche de revêtement 5, 5' formée sur une face du substrat 3, 3'. En variante, la bande métallique 1, 1', ainsi que les plaques 13 et les plaques bipolaires 11 fabriquées à partir de cette bande 1, 1' peuvent comprendre une couche de revêtement 5, 5' du type défini précédemment sur chacune de leurs faces.

Une telle couche de revêtement sur les deux faces du substrat 3 ; 3' peut être obtenue en un seul passage ou en plusieurs passages, par exemple deux passages, dans l'enceinte de dépôt 20.

**Revendications**

1. Procédé de fabrication d'une bande (1 ;1') ou feuille métallique comprenant un substrat (3 ;3') constitué d'acier inoxydable revêtu d'au moins une couche de revêtement (5 ;5') à base de nitrure de chrome, **caractérisée en ce que** la couche de revêtement (5 ;5') à base de nitrure de chrome est texturée et **en ce que** la bande ou feuille métallique est constituée du substrat et de l'au moins une couche de revêtement à base de nitrure de chrome, comprenant des étapes de :

    - fournir un substrat (3 ; 3') en acier inoxydable comprenant, à sa surface, une couche passive (10) formée par oxydation naturelle de l'acier inoxydable du substrat (3;3')
    - décaper entièrement la couche passive (10) dans certaines zones au moins du substrat (3 ;3') ;
    - déposer du nitrure de chrome sur les zones du substrat (3 ;3') dans lesquelles la couche passive (10) a été décapée de sorte à former une couche de revêtement (5 ;5') à base de nitrure de chrome directement sur le substrat (3 ;3') en acier inoxydable, sans interposition d'une couche passive (10), la couche de revêtement (5 ;5') ainsi formée étant texturée,

    la couche de revêtement (5 ;5') à base de nitrure de chrome étant déposée par un procédé de dépôt physique en phase vapeur et on dépose le nitrure de chrome sur le substrat (3') dans une installation de dépôt comprenant une enceinte de dépôt (20) et une cible de chrome (22) disposée dans l'enceinte de dépôt (20), le substrat (3') défilant à travers l'enceinte de dépôt (20) selon une direction longitudinale, l'enceinte de dépôt (20) comprenant une zone de dépôt (30;30') et au moins une zone interdite (33) adjacente et en amont de la zone de dépôt (30;30') selon la direction longitudinale, la zone de dépôt (30,30') présentant une longueur strictement inférieure à la longueur de l'enceinte de dépôt (20), dans laquelle du chrome se déposerait sur le substrat (3 ; 3') en l'absence de cette zone interdite (33), et
lors du dépôt, le nitrure de chrome est déposé sur le substrat (3') uniquement dans la zone de dépôt (30;30') et aucun nitrure de chrome n'est déposé sur le substrat (3') dans cette zone interdite (33).

2. Procédé selon la revendication 1, dans lequel la couche de revêtement (5 ;5') ainsi formée présente une relation d'épitaxie avec le substrat (3 ;3').

3. Procédé selon l'une quelconque des revendications 1 et 2, dans lequel le décapage est un décapage physique.

4. Procédé selon l'une des revendications 1 à 3, dans lequel la couche de revêtement (5 ;5') à base de nitrure de chrome est déposée par pulvérisation cathodique.

5. Procédé selon l'une quelconque des revendications 1 à 4 dans laquelle le substrat (3 ;3') présente une épaisseur comprise entre 75 micromètres et 200 micromètres, et en particulier une épaisseur inférieure ou égale à 100 micromètres.

6. Procédé selon l'une quelconque des revendications 1 à 5, dans laquelle les grains du substrat (3 ;3') ont une taille strictement inférieure à 50 micromètres, et en particulier comprise entre 10 micromètres et 30 micromètres.

7. Procédé selon l'une quelconque des revendications 1 à 6, dans laquelle la couche de revêtement (5 ;5') présente une structure colonnaire, la largeur des colonnes étant de préférence comprise entre 10% et 20% de l'épaisseur de la couche de revêtement (5 ;5').


**Patentansprüche**

1. Verfahren zum Herstellen eines Metallbandes (1, 1') oder -blechs, welches ein Substrat (3, 3') aufweist, welches aus einem rostfreien Stahl gebildet ist, welcher mit mindestens einer Überzugsschicht (5, 5') auf Basis von Chromnitrid überzogen ist, **dadurch gekennzeichnet, dass** die Überzugsschicht (5, 5') auf Basis von Chromnitrid texturiert ist, und dadurch, dass das Metallband oder -blech aus dem Substrat und aus der mindestens einen Überzugsschicht auf Basis von Chromnitrid gebildet ist, welches die folgenden Schritte aufweist:

   - Bereitstellen eines Substrats (3, 3') aus rostfreiem Stahl, welches auf seiner Oberfläche eine passive Schicht (10) aufweist, welche mittels natürlicher Oxidation des rostfreien Stahls des Substrats (3, 3') gebildet ist,
   - vollständiges Entfernen der passiven Schicht (10) zumindest in bestimmten Zonen des Substrats (3, 3'),
   - Abscheiden des Chromnitrids auf den Zonen des Substrats (3, 3'), in welchen die passive Schicht (10) entfernt worden ist, um eine Überzugsschicht (5, 5') auf Basis von Chromnitrid direkt auf dem Substrat (3, 3') aus rostfreiem Stahl zu bilden, ohne das Einfügen einer passiven Schicht (10), wobei die auf diese Weise gebildete Überzugsschicht (5, 5') texturiert ist,

   wobei die Überzugsschicht (5, 5') auf Basis von Chromnitrid mittels eines physikalischen Dampfphasenabscheidungsverfahrens abgeschieden wird und man das Chromnitrid auf dem Substrat (3') in einer Abscheidungsanordnung abscheidet, welche eine Abscheidungskammer (20) und ein Chromziel (22), welches in der Abscheidungskammer (20) angeordnet ist, aufweist, wobei das Substrat (3') die Abscheidungskammer (20) entlang einer Längsrichtung durchquert,
   wobei die Abscheidungskammer (20) eine Abscheidungszone (30, 30') und mindestens eine verbotene Zone (33), welche benachbart zu und entlang der Längsrichtung stromaufwärts von der Abscheidungszone (30, 30') ist, aufweist, wobei die Abscheidungszone (30, 30') eine Länge hat, welcher strikt kleiner ist als die Länge der Abscheidungskammer (20), und wobei das Chrom sich in Abwesenheit dieser verbotenen Zone (33) auf dem Substrat (3, 3') abscheiden würde, und
   wobei beim Abscheiden das Chromnitrid auf dem Substrat (3') nur in der Abscheidungszone (30, 30') abgeschieden wird und kein Chromnitrid auf dem Substrat (3') in dieser verbotenen Zone (33) abgeschieden wird.

2. Verfahren gemäß Anspruch 1, wobei die derart gebildete Überzugsschicht (5, 5') eine epitaktische Beziehung mit dem Substrat (3, 3') hat.

**3.** Verfahren gemäß irgendeinem der Ansprüche 1 und 2, wobei das Entfernen ein physisches Entfernen ist.

**4.** Verfahren gemäß einem der Ansprüche 1 bis 3, wobei die Überzugsschicht (5, 5') auf Basis von Chromnitrid mittels Kathodenzerstäubung abgeschieden wird.

**5.** Verfahren gemäß irgendeinem der Ansprüche 1 bis 4, wobei das Substrat (3, 3') eine Dicke, welche zwischen 75 Mikrometern und 200 Mikrometern liegt, und insbesondere eine Dicke, welcher kleiner oder gleich 100 Mikrometer ist, hat.

**6.** Verfahren gemäß irgendeinem der Ansprüche 1 bis 5, wobei die Körner des Substrats (3, 3') eine Größe haben, welche strikt kleiner als 50 Mikrometer ist, und welche insbesondere zwischen 10 Mikrometern und 30 Mikrometern liegt.

**7.** Verfahren gemäß irgendeinem der Ansprüche 1 bis 6, wobei die Überzugsschicht (5, 5') eine Säulenstruktur hat, und wobei die Breite der Säulen vorzugsweise zwischen 10% und 20% der Dicke der Überzugsschicht (5, 5') liegt.


**Claims**

**1.** A method for manufacturing a metal strip (1; 1') or sheet comprising a substrate (3; 3') made of stainless steel covered with at least one layer of a chromium-nitride based coating (5; 5'), **characterized in that** the chromium-nitride based coating layer (5; 5') is textured and wherein the metal strip or sheet is made of the substrate and the at least one layer of a chromium-nitride based coating, comprising the following steps:

- providing a stainless steel substrate (3; 3') comprising, on its surface, a passive layer (10) formed by natural oxidation of the stainless steel of the substrate (3; 3');
- completely stripping the passive layer (10) in at least certain areas of the substrate (3; 3');
- depositing chromium nitride on the areas of the substrate (3; 3') in which the passive layer (10) has been stripped so as to form a chromium-nitride based coating layer (5; 5') directly on the stainless steel substrate (3; 3'), without interposition of a passive layer (10), the coating layer (5; 5') thus formed being textured,

the chromium-nitride based coating layer (5; 5') being deposited using a physical vapor deposition method and the chromium nitride is deposited on the substrate (3') in a deposition installation comprising a deposition chamber (20) and a chromium target (22) arranged in the deposition chamber (20), the substrate (3') traveling through the deposition chamber (20) in a longitudinal direction,
the deposition chamber (20) comprising a deposition area (30; 30') and at least a prohibited area (33) adjacent to and upstream the deposition area (30; 30') in the longitudinal direction, the deposition area (30; 30') having a length strictly smaller than the length of the deposition chamber (20), in which chromium would be deposited on the substrate (3;3') in the absence of this prohibited zone (33),
during the deposition, the chromium nitride is deposited on the substrate (3') only in the deposition area (30; 30') and no chromium nitride is deposited on the substrate (3') in the first prohibited area (33).

**2.** The method according to claim 1, wherein the coating layer (5; 5') thus formed has an epitaxial relationship with the substrate (3; 3').

**3.** The method according to any one of claims 1 and 2, wherein the stripping is a physical stripping.

**4.** The method according to one of claims 1 to 3, wherein the chromium-nitride based coating layer (5; 5') is deposited using a physical vapor deposition method, in particular by cathode sputtering.

**5.** The method according to one of claims 1 to 4, wherein the substrate (3; 3') has a thickness comprised between 75 micrometers and 200 micrometers, and in particular a thickness smaller than or equal to 100 micrometers.

**6.** The method according to one of claims 1 to 5, wherein the grains of the substrate (3; 3') have a size strictly smaller than 50 micrometers, and in particular comprised between 10 micrometers and 30 micrometers.

**7.** The method according to one of claims 1 to 6, wherein the coating layer (5; 5') has a columnar structure, the width of the columns preferably being comprised between 10% and 20% of the thickness of the coating layer (5; 5').

Fig.1

Fig.2

*Fig.3*

*Fig.4*

*Fig.5*

5     3

*Fig.6*

5     10     3

Fig.7

Fig.8

**Fig.9**

**Fig.10**

Fig.11

Fig.12

*Fig.13*

*Fig.14*

*Fig.15*

Fig.16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120118724 A
- WO 2013124690 A
- US 20050238873 A